# EUROPÄISCHE PATENTSCHRIFT

(11) **EP 0 721 587 B1**
(45) Veröffentlichungstag und Bekanntmachung des Hinweises auf die Patenterteilung: **02.12.1998**
(21) Anmeldenummer: 94927478.1
(22) Anmeldetag: 22.09.1994
(51) Int. Cl.: G01P 15/08

(54) **MIKROMECHANISCHE VORRICHTUNG UND VERFAHREN ZU DEREN HERSTELLUNG**
MICROMECHANICAL DEVICE AND PROCESS FOR PRODUCING THE SAME
DISPOSITIF MICROMECANIQUE ET SON PROCEDE DE FABRICATION

(30) Priorität: 27.09.1993 DE 4332843
(43) Veröffentlichungstag der Anmeldung: 17.07.1996
(73) Patentinhaber: SIEMENS AKTIENGESELLSCHAFT, 80333 München (DE)
(72) Erfinder: WERNER, Wolfgang, D-81545 München (DE)
(86) Internationale Anmeldenummer: DE9401103
(87) Internationale Veröffentlichungsnummer: WO9509366

(56) Entgegenhaltungen:
- EP-A- 0 451 992
- EP-A- 0 456 029
- EP-A- 0 591 554
- PROCEEDINGS IEEE;MICRO ELECTRO MECHANICAL SYSTEMS,IEEE CAT.NR. 93CH3265-6; LIBRARY OF CONGRESS, Bd.92-56273, 7. Februar 1993, FORT LAUDERDALE, FLORIDA Seiten 77 - 81, XP366859 MASTRANGELO ET AL 'A DRY-RELEASE METHOD BASED ON POLYMER COLUMNS FOR MICROSTRUCTURE FABRICATION'

## Beschreibung

Die Erfindung betrifft eine mikromechanische Vorrichtung und ein Verfahren zu ihrer Herstellung.

Mikromechanische Vorrichtungen wie Sensoren oder Aktuatoren finden zunehmend Eingang in alle Bereiche der Technik, z. B. in Navigationssysteme und Kraftfahrzeuge, insbesondere in Verbindung mit Sicherheitssystemen. Einen großen Teil derartiger Vorrichtungen bilden Druck- und Beschleunigungssensoren. Gefragt sind zuverlässige, kleine, einfach herzustellende und dabei preiswerte Sensoren mit einer hohen Meßgenauigkeit und einer guten Proportionalität zwischen Meßgröße und Ausgangssignal. Dies gilt entsprechend für Aktuatoren, so daß nachfolgend der Einfachheit halber lediglich auf Sensoren eingegangen wird.

Die meisten heute verwendeten Druck- oder Beschleunigungssensoren werden feinmechanisch oder mittels KOH-Ätztechnik auf Siliziumbasis (bulk-micromachining) hergestellt. Die Auswertung des bislang meist mittels des Piezoeffekts erzeugten Sensorsignals erfolgt getrennt vom Sensor. Der Trend geht jedoch zum intelligenten Sensor, bei dem der Sensor sowie die Schaltung zur Auswertung des Sensorsignals und gegebenenfalls eine Testschaltung auf Basis der Siliziumplanartechnologie auf einem Chip integriert sind. Die Auswertung des piezoresistiven oder kapazitiven Sensorsignals sowie die Linearisierung und Verstärkung erfolgen mit Halbleiterschaltkreisen bekannter Technologien. Ein derartiger Sensor ist beispielsweise aus der Veröffentlichung F. Goodenough: Airbags Boom When IC Accelerometer Sees 50 G, Electronic Design, August 8, 1991, pp. 45-56 bekannt.

Während konventionell hergestellte mikromechanische Sensoren relativ groß, teuer und ungenau sind, beschreibt die vorstehend genannte Veröffentlichung eine verbesserte Ausführungsform. Dieser bekannte sogenannte oberflachen-mikromechanische Sensor (surface micromachining) benötigt, wie insbesondere aus der diesbezüglichen weiteren Veröffentlichung: Analog Devices Combines Micromachining and BICMOS, Semiconductor International, Okt. 1991 hervorgeht, zu seiner Herstellung 21 Masken, nämlich 6 Masken für den Sensorprozeß und 15 Masken für einen 4 µm-BICMOS-Prozeß. Das zur Ausbildung des kapazitiven Sensors kammförmige Sensorelement besteht aus einem 2µm-dicken Polysiliziumelement und ist über Federn, die ebenfalls aus Polysilizium sind, mit der Substratoberfläche verbunden.

Eine weitere kapazitive Struktur ist aus der US-A-5 025 346 bekannt.

Das Herstellverfahren für die bekannten Sensoren bzw. Aktuatoren ist außerordentlich aufwendig und teuer. Darüberhinaus ist unsicher, ob die für die mechanisch bewegten Teile eines Sensors verwendeten Polysiliziumschichten eine ausreichende mechanische Langzeitstabilität aufweisen. Neben dieser möglichen zeitlichen Degradation sind die mechanischen Eigenschaften wie der Elastizitätsmodul oder intrinsischer Streß von Polysilizium sensibel von den jeweiligen Prozeßbedingungen während der Herstellung abhängig. Die thermische Ausheilung des intrinsischen Stresses erfordert im Herstellungsprozeß zusätzliche Temperschritte, was sich nachteilig auf die gleichzeitig in dem Sensor integrierte elektronische Schaltung auswirkt. Zudem sind im Herstellungsprozeß zusätzliche Abscheidungen von Halbleiterschichten notwendig. Bei einem denkbaren Einsatz von modernen Sub-µm-BICMOS-Schaltungen für die Auswerteschaltung des Sensors ist es aufgrund der dabei verwendeten niedrigen Prozeßtemperaturen nicht mehr möglich, streßfreie Polysiliziumschichten herzustellen.

Ein Problem betrifft die Verarbeitung von mikromechanischen, gegebenenfalls integrierten mikromechanischen Vorrichtungen, die auf einem Halbleiterwafer hergestellt sind. Zum Vereinzeln der Chips wird der Wafer dünngeschliffen und anschließend werden die einzelnen Chips gesagt. Dabei muß das filigrane Gebilde der mikromechanischen Vorrichtung auf deren Vorderseite mit einer Folie abgedeckt werden. Für die Verarbeitung ist ein Reinraum erforderlich, damit nicht Partikel in die mikromechanische Vorrichtung gelangen können, die deren Brauchbarkeit beeinträchtigen oder die Vorrichtung unbrauchbar lassen werden könnten. Diese Verarbeitungsweise ist teuer und auch bei großen Stückzahlen wenig praktikabel.

Eine als Chip vereinzelte mikromechanische Vorrichtung muß zum Schutz gegen äußere Einflüsse in ein Gehäuse eingebracht werden. Für bekannte Vorrichtungen scheidet ein Plastikgehäuse aus, da bei der Plastikummantelung des Chips die Beweglichkeit des Sensors verlorengeht. Verpressdrücke bis zu 80 bar können zur völligen Zerstörung der mikromechanischen Vorrichtung führen. Üblicherweise wird deshalb ein mikromechanischer Chip in ein Hohlraumgehäuse eingebaut, das allerdings etwa um den Faktor 10 teurer als ein Plastikgehäuse ist.

Aus den Veröffentlichungen K. Ikeda et. al.: Silicon pressure sensor with resonant strain gauge built into diaphragm, Proc. of the 7th Sensor Symp., Tokyo, Japan, 1988, pp. 55-58 und K. Ikeda et. al.: Three-dimensional micromachining of silicon pressure sensor integrating resonant strain gauge on diaphragm, Sensors and Actuators, A21-A23, 1990, pp. 1007-1010 sind mikromechanische Drucksensoren mit einem Polysilizium-Diaphragma bekannt, auf dem ein auf mechanische Spannungen reagierender Resonator angeordnet ist. Bei einer Verbiegung des Diaphragmas ändert sich die Resonanzfrequenz des Resonators auf Grund der mechanischen Spannungen. Damit der von außen ausgeübte Druck nicht direkt auf den Resonator wirken und auf diese Weise zu Meßsignalverfälschungen führen kann, ist der Resonator auf dem Diaphragma mit einer Kappe abgedeckt. Auch ein derartiger Sensor muß zum Schutz gegen Umwelteinflüsse in ein Hohlraumgehäuse eingebaut werden.

In der EP-A 0 451 992 ist eine mikromechanische Vorrichtung und ein entsprechendes Herstellungsverfahren beschrieben, welche ein bewegliches Element aus Polysilizium aufweist, das sich in einem Hohlraum befindet. Der Hohlraum ist durch eine Oxidschicht geschlossen.

Die Erfindung hat die Aufgabe, eine einfacher und kostengünstiger herzustellende mikromechanische Vorrichtung und ein Verfahren zu deren Herstellung anzugeben.

Gemäß eines Aspekts der Erfindung sind bei einem verfahren zur Herstellung einer mikromechanischen Vorrichtung die im Anspruch 1 genannten Schritte vorgesehen.

Gemäß einem weiteren Aspekt der Erfindung ist eine mikromechanische Vorrichtung vorgesehen, die auf einem Träger einen mit Hilfe einer Siliziumschicht gebildeten mikromechanischen Bereich enthält, wobei auf dem Träger unter Bildung eines abgeschlossenen Hohlraums eine flächige Abdeckung des mikromechanischen Bereichs angeordnet ist. Die Vorrichtung enthält die im Anspruch 10 genannten Merkmale.

Die Erfindung hat den Vorteil, daß die auf einem Chip realisierte mikromechanische Vorrichtung bereits auf dem Chip eine Abdeckung hat, die in der Prozeßlinie in Verbindung mit der Herstellung der mikromechanischen Vorrichtung hergestellt wird. Bei der Verarbeitung des Wafers mit den mikromechanischen Vorrichtungen, d.h. u.a. beim Herstellen von Anschlußverbindungen, beim Läppen und beim Vereinzeln der Chips ist deshalb keine Reinraumatmosphäre mehr erforderlich. Darüber hinaus braucht der Chip nicht mehr in einem Hohlraumgehäuse montiert zu werden, sondern kann mit einem preisgünstigen Plastikgehäuse ummantelt werden. Es ergibt sich eine wesentlich erhöhte Zuverlässigkeit der mikromechanischen Vorrichtung, da die Vorrichtung unmittelbar nach der Herstellung noch auf dem Wafer mit einer Abdeckung versehen ist und somit für die nachfolgenden Verfahrensschritte ausreichend geschützt ist. Die Beweglichkeit des Sensors bleibt erhalten, weil durch die Abdeckung ein abgeschlossener Hohlraum gebildet wird, in dem die beweglichen Elemente angeordnet sind.

Die Erfindung hat den weiteren Vorteil, daß sie sich sowohl für bekannte mikromechanische Vorrichtungen, die in polykristallinem Silizium verwirklicht sind, als auch für Vorrichtungen eignet, in denen der aktive Bereich in einkristallinem Silizium realisiert ist. Einkristallines Silizium besitzt genau bekannte mechanische Eigenschaften, die nicht von den jeweiligen Parametern des Herstellungsprozesses abhängen. Zudem sind die mechanischen Eigenschaften keiner zeitlichen Degradation unterworfen, so daß die Langzeitstabilität sehr groß ist.

Die Erfindung hat den weiteren Vorteil, daß sie unter Verwendung bekannter und verfügbarer Grabenätz- und Auffüllverfahren in vollem Umfang VLSI-kompatibel ist. Weiterhin ist die erfindungsgemäße Vorrichtung mechanisch robust, da sich die beweglichen Teile in der Siliziumschicht befinden und nicht auf der Chipoberfläche.

Wenn Elektroden des Sensors senkrecht zur Chipoberfläche stehen ergibt sich eine hohe spezifische Kapazität (Packungsdichte) des Sensors. Gleichzeitig wird das Sticking-Problem, d. h. eine Adhäsion von Flächen beim oder nach einem Spülvorgang entschärft, da die Steifigkeit der Sensorvorrichtung senkrecht zur Schwingungsrichtung sehr groß ist.

Schließlich bietet die erfindungsgemäße Vorrichtung bei einer Integration der Auswerteschaltung den erheblichen Vorteil, daß bei der Verwendung eines bipolaren oder eines BICMOS-Prozesses die Maskenzahl zur Herstellung der Vorrichtung gegenüber einem Standardprozeß in diesen Technologien nicht oder nur unwesentlich erhöht wird.

Ausgestaltungen der Erfindung sind in Unteransprüchen gekennzeichnet.

Die Erfindung wird nachfolgend anhand zweier Ausführungsbeispiele in den Figuren der Zeichnung näher erläutert, in denen gleiche Elemente gleiche Bezugszeichen haben. Es zeigen:
- Figuren 1 bis 5: Querschnitte durch eine erste erfindungsgemäße Vorrichtung bei verschiedenen Herstellungsverfahrensschritten,
- Figur 6: einen Querschnitt durch einen Teilbereich einer kapazitiven Vorrichtung,
- Figur 7: einen Schnitt durch eine kapazitive Vorrichtung gemäß Figur 6 in einem größeren Ausschnitt,
- Figur 8: einen Teil-Querschnitt durch eine zweite erfindungsgemäße Vorrichtung und
- Figur 9: einen anders liegenden Querschnitt durch die Vorrichtung von Figur 8 mit größerem Ausschnitt.

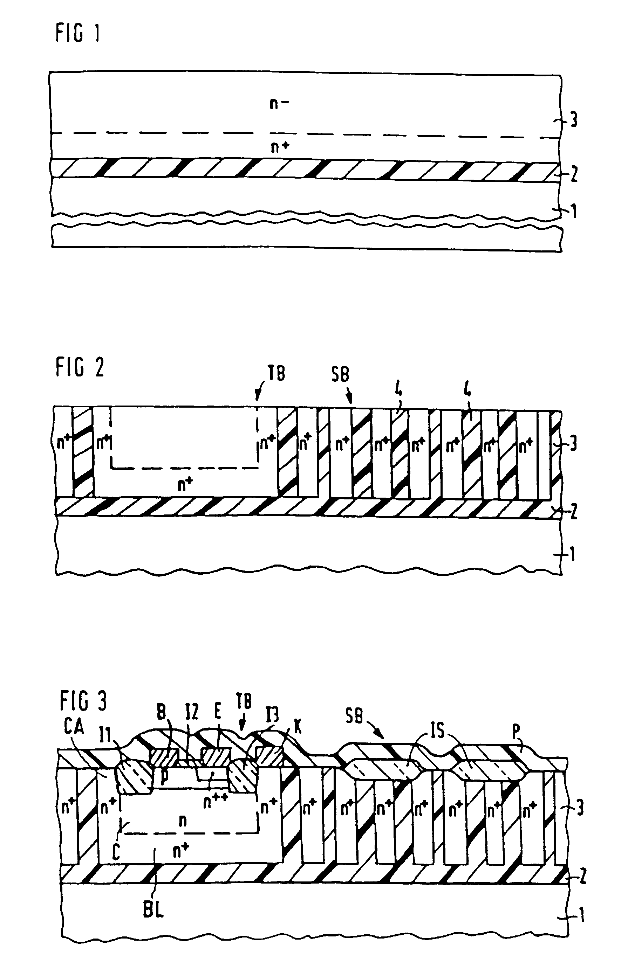

Figur 1 zeigt an einem ersten Ausführungsbeispiel einen bei der Herstellung der mikromechanischen Vorrichtung gebildeten Grundkörper. Auf einem Träger oder Substrat 1 ist eine erste Isolierschicht 2 und auf dieser Isolierschicht eine einkristalline Siliziumschicht 3 angeordnet. Das Substrat kann ebenfalls aus Silizium bestehen. Typischerweise wird die Dicke der ersten Isolierschicht 2 zwischen 0,5 und 1 µm gewählt, während die Schichtdicke der Siliziumschicht 3 z. B. zwischen 5 und 20 µm betragen kann. Die Kristallorientierung und Dotierung des Substrats ist beliebig. Die Orientierung und Dotierung der Siliziumschicht 3 entspricht der bei der Herstellung der mikromechanischen Vorrichtung und einer integrierten Halbleiterschaltungsanordnung verwendeten Basistechnologie.

Gemäß Figur 1 ist die der Isolierschicht 2 bzw. die der unteren Grenzfläche der Siliziumschicht zugewandte Seite der Siliziumschicht 3 n⁺-dotiert, während die von der Isolierschicht 2 abgewandte Oberflächenzone der Siliziumschicht n⁻-dotiert ist. Die Dotierung der Siliziumschicht 3 ist für das eigentliche Sensorelement nicht notwendig, sondern richtet sich ausschließlich nach der Technologie, die für die zu integrierende Schaltungsanordnung verwendet werden soll.

Der Grundkörper gemäß Figur 1 kann z. B. eine DWB-Scheibe sein, wobei DWB Direct-Wafer-Bonding bedeutet. Derartige Scheiben sind aus zwei Halbleiterscheiben zusammengeklebt und lassen sich mit hoher Qualität mit den in Figur 1 gezeigten Schichtdicken und Dotierungen am Markt erwerben. Eine weitere Möglichkeit zur Herstellung des in Figur 1 gezeigten Grundkörpers ist die Verwendung des sogenannten SIMOX-Verfahrens (I. Ruge, H. Mader: Halbleiter-Technologie, Springer-Verlag, 3. Auflage, 1991, Seite 237). Dabei wird eine Isolierschicht aus Siliziumoxid durch tiefe Ionenimplantation von Sauerstoffatomen in einkristallines Silizium gebildet. Daran kann sich ein Epitaxieschritt anschließen. Eine dritte Möglichkeit zur Herstellung des Grundkörpers gemäß Figur 1 macht von der Rekristallisation Gebrauch, bei der eine über einer einkristallinen Siliziumschicht und einer darauf angeordneten Siliziumoxidschicht zunächst amorph oder polykristallin abgeschiedene Siliziumschicht durch Aufschmelzen mit einem Laserstrahl rekristallisiert wird.

In einem nächsten Schritt werden in die einkristalline Siliziumschicht 3 Gräben bis auf die Oberfläche der Isolierschicht 2 geätzt, beispielsweise durch eine anisotrope Trockenätzung. Anschließend werden die Gräben mit einem dotierenden Isolierstoff aufgefüllt. Im Ausführungsbeispiel gemäß Figur 2 kann Phosphorglas (PSG) oder Borphosphorglas (BPSG) verwendet werden. Die Erzeugung derartiger Glasschichten ist beispielsweise aus D. Widmann, H. Mader, H. Friedrich: Technologie hochintegrierter Schaltungen, Springer-Verlag, 1988, Seite 80 ff. bekannt. Bei einer entsprechenden Temperaturbehandlung diffundieren Phosphor und gegebenenfalls Bor aus dem Phosphorglas in das Silizium der Grabenwände der Siliziumschicht 3 ein. Damit ergibt sich die in Figur 2 gezeigte Struktur, bei der die Isolierschicht 2 und die dotierende Isolierschicht 4 am Fuß der zuvor geätzten Gräben aufeinanderstoßen. Die Grabenwände sind entsprechend der an der Isolierschicht 2 angrenzenden Zone der Siliziumschicht 3 dotiert, d. h. im Ausführungsbeispiel n⁺-dotiert.

Durch das Ätzen von Gräben in der Siliziumschicht und das Dotieren der Grabenwände werden sowohl der Bereich SB, in dem der eigentliche Sensor vorgesehen ist, als auch der Bereich TB, in dem die elektronische Auswerteschaltung, zumindest aber eine Transistoranordnung für die Verarbeitung des Sensorsignals vorgesehen ist, strukturiert und gegeneinander isoliert. Der Bereich TB beinhaltet eine oder mehrere isolierte Wannen, in die je nach Vorgabe CMOS-, Bipolar- oder sonstige Bauelemente eingebaut werden. Wenn die im Bereich TB zu realisierende Transistoranordnung z. B. ein bipolarer Transistor ist, ist mit der in Figur 2 gezeigten Struktur des Bereichs TB bereits eine vergrabene Kollektorzone und ein niederohmiger Kollektor-Anschluß in Form der dotierten Grabenwände erzeugt. Gegenüber Anordnungen aus dem Stand der Technik erfordert die Erzeugung der in Figur 2 gezeigten Struktur keine separaten Masken- und Dotierungsprozesse für die vergrabene Zone, für einen Kanalstopper und für einen Kollektor. Ein Epitaxieprozeß kann ebenfalls entfallen.

Ausgehend von der Struktur der Figur 2 werden anschließend in den Bereichen TB und SB Isolationszonen, insbesondere Feldoxidbereiche durch lokale Oxidation und eine Transistoranordnung in dem Bereich TB erzeugt. Diese Transistoranordnung kann mit einem standardmäßigen bipolaren oder BICMOS-Prozeß hergestellt werden. Beispiele für derartige Prozesse sind z. B. aus der vorgenannten Veröffentlichung Widmann/Mader/Friedrich: Technologie hochintegrierter Schaltungen bekannt. Bei einer bipolaren Transistorstruktur kann z. B., ausgehend von Figur 2, zunächst die Basiszone, bei einem BICMOS-Prozeß zunächst die p-bzw. n-Wanne erzeugt werden.

Selbstverständlich ist es möglich, ausgehend von der Struktur der Figur 2 auch eine MOS-Transistoranordnung in dem Grundkörper zu realisieren. Auch in diesem Fall beginnt der standardmäßige Prozeß mit der Erzeugung einer p- bzw. n-Wanne in dem für die Transistorstrukturen vorgesehenen Bereich TB.

Die Herstellung der Feldoxidbereiche durch lokale Oxidation erfolgt mit den für den Transistorprozeß vorgesehenen Prozeßschritten gleichzeitig auch im Sensorbereich SB. Die Bereiche des Sensors, in denen die beweglichen Elemente bzw. Elektroden der Vorrichtung vorgesehen sind, erhalten ein Feldoxid IS, während die dazwischen angeordneten Bereiche von der lokalen Oxidation (LOCOS) ausgenommen werden. Gegebenenfalls werden vor dem LOCOS-Prozeß die Grabenfüllungen teilweise wieder entfernt, so daß nach dem Oxidationsprozeß der zwischen zwei Feldoxidbereichen liegende Oberflächenbereich, in dem keine beweglichen Elemente der Vorrichtung vorgesehen sind, niedriger liegt als die Oberfläche des Feldoxids über dem beweglichen Element, aber höher als die auf diesem Element angeordnete untere Grenzfläche des Feldoxids, Fig. 3, Bereich SB.

Während der Erzeugung der Transistoranordnung wird der Bereich SB, der für das Sensorelement vorgesehen ist, soweit erforderlich durch eine entsprechende Maske abgedeckt. Gemäß Figur 3 ergibt sich z. B. ein bipolarer Transistor, dessen Kollektor C niederohmig über die vergrabene Zone BL und die hochdotierten niederohmigen Grabenwände CA mit dem Kollektoranschluß K verbunden sind. Die p-dotierte Basis ist mit dem Basisanschluß B verbunden. Entsprechend ist der Emitteranschluß E über der hochdotierten n⁺⁺-Zone angeordnet. Basis-, Emitter- und Kollektorbereiche des Transistors sind über Isolationszonen I1 bis I3, vorzugsweise aus Siliziumoxid SiO₂, gegeneinander isoliert. Anschließend wird über der gesamten Anordnung, d.h. den Bereichen TB und SB, eine Passivierungsschicht P aufgebracht. Beispielsweise kann die Passivierungsschicht aus Siliziumnitrid Si₃N₄ bestehen.

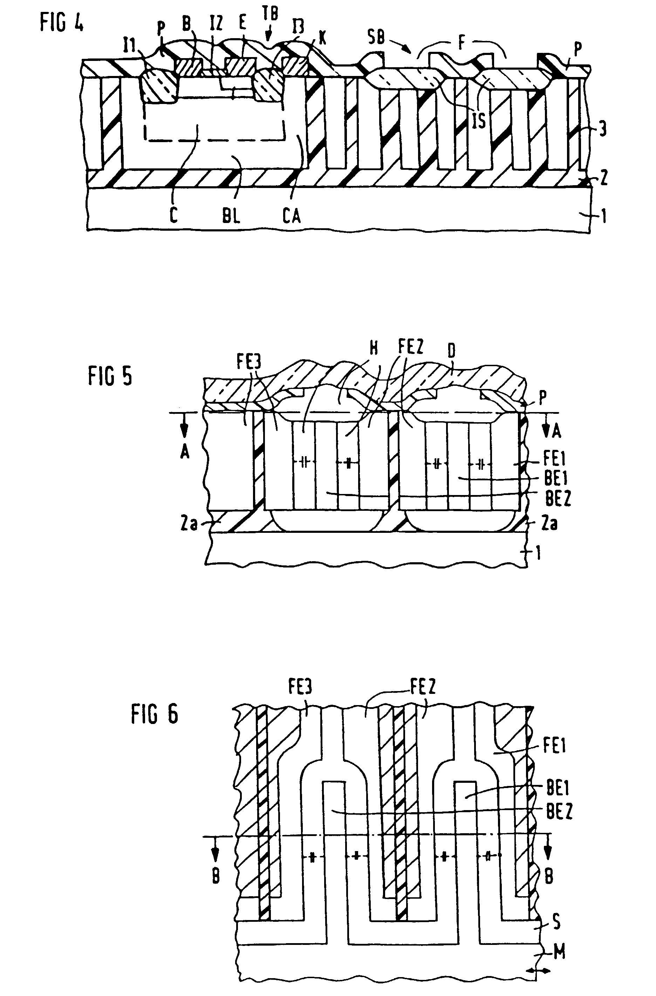

Im Anschluß an die Erzeugung der Transistoranordnung und der Passivierungsschicht P wird die Passivierungsschicht P in den Bereichen über dem Sensorbereich SB, in denen Feldoxid gebildet ist, mit Hilfe einer Lackmaske entfernt. Es entstehen Fenster F, Figur 4, mit einem Durchmesser von etwa 0,7 bis 1,5 µm. Danach werden selektiv das Feldoxid IS, der dotierende Isolierstoff 4 in den darunter liegenden Gräben des Sensorbereichs und die Isolierschicht 2 zumindest in Teilzonen des Sensorbereichs SB entfernt. Dies kann z. B. durch einen naßchemischen oder einen Trocken-Ätzprozeß ohne Lackabdeckung unter Verwendung der Passivierungsschicht P als Maske erfolgen. Die Isolierschicht 2 wird dabei unter den beweglichen Elektroden BE1, BE2 des Sensorelements vollständig und unter den nicht beweglichen Elektroden FE1 bis FE3 des Sensorelements nicht vollständig entfernt, so daß letztere weiterhin mechanisch mit dem Substrat 1 über Isolierstege 2a verbunden sind, Fig. 5.

Um ein möglicherweise bei der Entfernung der Isolierschicht 2 unter dem Bereich der beweglichen Elektroden BEi auftretendes Adhäsionsproblem (Sticking) zu lösen, können sublimierende Chemikalien, z. B. Cyclohexan oder Dichlorbenzol verwendet werden.

Es schließt sich die Abscheidung einer Abdeckschicht, z.B. aus Nitrid bzw. Plasmanitrid, Metall (Aluminium o.ä.) PSG, BPSG oder Polysilizium an, z.B. mit konformer Abbildung, wobei eine schlechte Kantenbedeckung erwünscht ist, um die Fenster F zu schließen. Geringe Abscheidungen auf den Elektroden BE1, BE2, FE1 bis FE3 sowie der Substratoberfläche sind zulässig und erwünscht, weil es als Antistickingmaßnahme (Anti-Kaltverschweiß-Maßnahme) dient.

Figur 5 zeigt im Querschnitt eine Anordnung nach dem Entfernen des Isolierstoffs 4 und der Isolierschicht 2 neben und unter den beweglichen Elektroden BE1, BE2 des Sensorbereichs SB, während unter den festen Elektroden FE1, FE2 und FE3 die Isolierschicht 2a noch teilweise vorhanden ist. Über der Anordnung gemäß Figur 5 ist eine flächige Abdeckung D aus (Plasma)Nitrid, Metall, PSG, BPSG oder Polysilizium vorhanden, die die mikromechanische Vorrichtung und die integrierte Transistoranordnung vollständig gegen äußere Einflüsse schützen kann. Zur Verbesserung der mechanischen Festigkeit kann die Abdeckung D mehrschichtig aufgebaut sein, z. B. durch sukzessives Aufbringen von Schichten. Die Schichten können aus den bei der Herstellung der Schaltung ohnehin verwendeten Materialien, also z. B. Metallisierungsschichten (Aluminium) oder Intermetalldielektrika bestehen. Die Dimensionierung erfolgt so, daß die Abdeckung D den bei der Umhüllung des Bauelements auftretenden Verpreßdrücken, z. B. 80 bar, standhält. Es entsteht ein abgeschlossener Hohlraum, in dem die beweglichen Elemente des Sensors angeordnet sind.

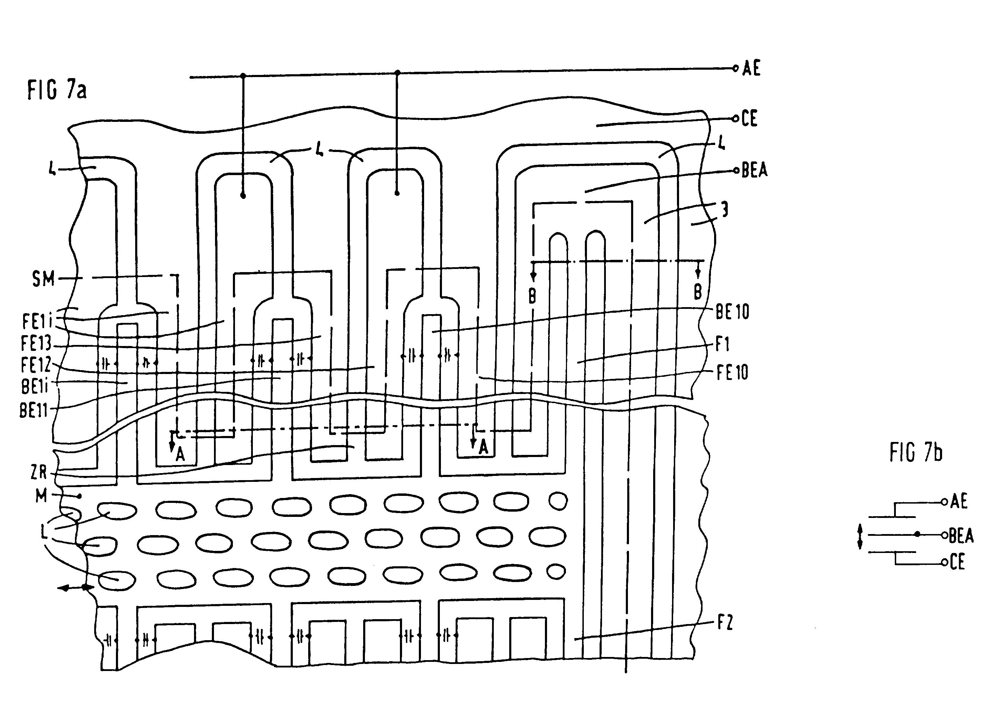

Der in Figur 5 gezeigte Querschnitt B-B stellt eine Sensorstruktur dar, die Figur 6 im Querschnitt A-A zeigt. In Figur 7 ist schematisch ein größerer Ausschnitt aus dem Sensorbereich skizziert. Es handelt sich um einen Beschleunigungssensor, der ein bewegliches Masseteil M hat, das über Federelemente F1, F2 und weitere nicht dargestellte Federelemente an der Siliziumschicht 3 aufgehängt ist. Das Masseteil M hat fingerförmige bewegliche Elektroden BE1, BE2 bzw. BE10, BE11 und BE1i, die frei in Bereiche zwischen festen Elektroden FE1 bis FE3 bzw. FE10 bis FE13 sowie FE1i, hineinragen. Zwischen den beweglichen Elektroden BEi bzw. BEij und den festen Elektroden FEi bzw. FEij sind, da die Grabenwände der Elektroden hochdotiert sind, Kapazitäten gebildet, die in den Figuren 5 bis 7 rein symbolisch dargestellt sind. Die Buchstaben i und j der Bezugselemente symbolisieren Laufvariable. Um bei der Herstellung des Sensorteils die Isolierschicht unter dem Masseteil zuverlässig entfernen zu können, enthält das Masseteil M Löcher L. Die Lochöffnungen betragen etwa 0,7 bis 1,5 µm (kreisförmig bzw. elliptisch), der Lochmittenabstand etwa 5 bis 8 µm. Grundsätzlich sind die Löcher jedoch nicht zwingend erforderlich. In Figur 7 ist der Bereich der Sondermaske, die für die Erzeugung der Sensorstrukturen verwendet wird, skizziert. Innerhalb des durch die Sondermaske SM definierten Bereichs erfolgt das Entfernen des dotierenden Isolierstoffs aus den Gräben und der Isolierschicht neben und unterhalb der beweglichen Elektroden, des Masseteils und der Federn vollständig.

Figur 7b) zeigt das mit der Sensorstruktur von Figur 5 bzw. Figur 6 erhaltene Ersatzschaltbild. Die beweglichen Elektroden BEi, d.h. BE10 bis BEli sind über das Masseteil M und die Feder Fi mit einem Anschluß BEA verbindbar. Die festen Elektroden sind paarweise mit Anschlüssen AE und CE verbunden, die den festen Platten eines Kondensators entsprechen. Die beweglichen Elektroden bilden eine bewegliche Platte des Kondensators, so daß Figur 7b) einen Differentialkondensator darstellt.

In den Spalten S zwischen den beweglichen und festen Elektroden wird der Isolierstoff vollständig entfernt, Figur 6. Aus den Zwischenräumen ZR zwischen zwei festen Elektroden, Figur 7, kann der dotierende Isolierstoff entfernt werden. Es ist jedoch auch möglich, daß die Zwischenräume ZR der festen Elektroden und die darunterliegende Isolierschicht, die den jeweiligen festen Elektroden zugewandt ist, erhalten bleiben. Voraussetzung ist eine andere Maske, mit der sich nur die Isolierschicht und der dotierende Isolierstoff unterhalb und zwischen den beweglichen Elektroden entfernen lassen.

Die festen Elektroden können alternativ zu der Struktur von Figur 6 bzw. Figur 7 in ähnlicher Weise wie in der zuvor zitierten Veröffentlichung Electronic Design mit dem Substrat 1 bzw. der Isolierschicht 2 mechanisch verbunden sein. Die Befestigung über einen Anker hat freitragende Elektroden zur Konsequenz, was bedeutet, daß die festen Elektroden hinsichtlich auf sie wirkender Beschleunigungskräfte ausreichend biegesteif sein müssen, damit zusätzliche Meßfehler nicht negativ auf die Meßgenauigkeit wirken.

Die in den Figuren 6 und 7 dargestellte Sensoranordnung reagiert sensibel auf Bewegungen des Masseteils M in der angedeuteten Pfeilrichtung. Die zulässige Auslenkung der fingerförmigen kapazitiven beweglichen Elektroden beträgt weniger als der Spaltabstand zu einer festen Elektrode, d. h. weniger als etwa 0,5 bis 1,5 µm. Vorzugsweise ist deshalb die Auswerteschaltung der Sensorvorrichtung als Regelkreis derart ausgestaltet, daß eine Regelspannung einer Auslenkung des Masseteils in dem Sinne entgegenwirkt, daß die durch den Differentialkondensator gebildeten Teilkapazitäten jeweils gleich sind. Dieses Verfahren hat den Vorteil, daß es ein Nullpunktverfahren ist und deshalb in der Regel genauer ist als ein absolutes Verfahren zur Bestimmung der Kapazitätsänderungen.

Eine zweidimensionale Beschleunigungsmessung ist möglich, wenn zwei Sensoranordnungen gemäß Figur 6 bzw. Figur 7 verwendet werden, die zueinander um 90°versetzt sind. Die Schwingungsrichtung der jeweiligen Masseteile liegt dabei in der Schwingungsrichtung der Chipebene in zwei zueinander senkrechten Richtungen. Die beschriebene Technik läßt sich in ähnlicher Weise auf die Herstellung von Differenzdrucksensoren anwenden.

Bei größeren abzudeckenden Bereichen der Vorrichtung, für die keine freitragende Abdeckung D möglich ist, sind Stützen vorgesehen, die von den beweglichen Elektroden vollständig getrennt sind. (Zur Ausführung wird auf das zweite Ausführungsbeispiel verwiesen.)

Die Erfindung nach dem ersten Ausführungsbeispiel hat zusätzlich zu den sich mit der Abdeckung D ergebenden Vorteilen folgende weitere Vorteile:

Das Sensormasseteil, die Elektroden und der Biegebalken, d. h. die Aufhängefedern des Sensors bestehen aus Monosilizium, so daß für die beweglichen Teile die von Polysilizium her bekannten Verbiegungen und Spannungen entfallen.

Das Masseteil des Sensors und die Federkonstante des Biegebalkens sowie bei einem kapazitiven Sensor die Sensorkapazität sind unabhängig voneinander einstellbar, so daß sich gut Sensorarrays realisieren lassen. Die Sensoranordnung erlaubt eine hohe Packungsdichte des Sensors, da die Elektroden senkrecht zur Chipoberfläche stehen, so daß sich eine große kapazitive Fläche erzielen läßt. Die Steifigkeit der Elektroden senkrecht zur Schwingungsrichtung ist sehr groß, da das Widerstandsmoment proportional zur 3. Potenz der Elektrodendicke ist. Aus diesem Grund tritt gegebenenfalls kein Adhäsions- bzw. Stickingproblem auf, so daß gegenwirkende Chemikalien nicht erforderlich sind.

Da sich die beweglichen Teile des Sensors im Silizium bzw. in der Siliziumschicht befinden und nicht auf der Chipoberfläche ist der Sensor mechanisch außerordentlich robust. Durch die Anordnung der Elektroden und des Masseteils in der Chipebene ist außerdem automatisch eine Überlastsicherung in der Chipebene gegeben.

Bei Verwendung eines bipolaren oder eines BICMOS-Standardprozesses als Basistechnologie für die Auswerteschaltung des intelligenten Sensors wird die Maskenzahl nicht erhöht. Dadurch lassen sich erhebliche Kosten sparen und der Herstellungsprozeß insgesamt vereinfachen.

Grundsätzlich ist das erfindungsgemäße Verfahren bzw. die Sensorvorrichtung kombinierbar mit allen bekannten Technologien. Insbesondere ist die Sensorvorrichtung VLSI-kompatibel, so daß Strukturbreiten unter 1µm erzielt werden können. Verwendung bei der Herstellung können deshalb die aus der Halbleitertechnologie bekannten Grabenätz- und Auffüllverfahren sowie die üblichen Halbleiterverfahren finden.

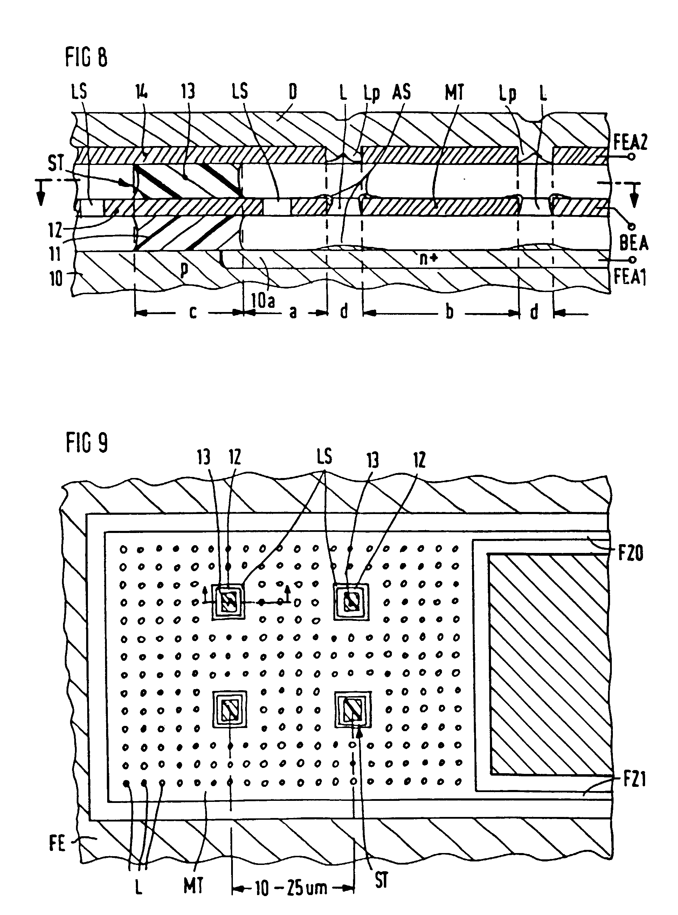

Die Figuren 8 und 9 zeigen ein weiteres Ausführungsbeispiel der Erfindung. Es handelt sich um einen Beschleunigungssensor mit einem Masseteil MT, das über Federelemente F 20 bzw. F21 in einem Halbleiterkörper aufgehängt ist. Das Masseteil MT kann ähnlich wie bei der in Figur 7 gezeigten Anordnung als bewegliche Elektrode eines Differentialkondensators aufgefaßt werden. Das Masseteil ist gemäß Figur 8 mit einem Anschluß BEA verbunden, während die beiden festen Elektroden 10 und 14 mit entsprechenden Anschlüssen FEA 1 bzw FEA 2 verbunden sind. Die feste Elektrode 10 besteht aus einem Halbleitersubstrat, in dem eine n⁺- leitende Wanne 10a eingebettet ist.

Bei den vergleichsweise großen Abmessungen des Sensors sind im Bereich des Masseteils MT Stützen ST für den Deckel D vorgesehen. Die Figuren 8 und 9 zeigen entsprechende Schnitte bzw. Teilschnitte durch die markierten Ebenen. Die Stützen ST sind durch einen Luftspalt LS vollständig von dem beweglichen Masseteil MT getrennt. In dem Masseteil sind Locher L vorgesehen, die beim Herstellungsprozeß zum Freiätzen des Sensorteils dienen.

Die Sturktur gemäß Figur 8 wird folgendermaßen hergestellt: Auf einem Substrat 10 mit der hochdotierten Zone 10a wird zunächst ganzflächig eine erste Isolierschicht, beispielsweise durch (lokale) Oxidation erzeugt. Danach wird eine Polysiliziumschicht aufgetragen, aus der durch Strukturieren die Bereiche 12 und das Masseteil MT entstehen. Bei der Strukturierung werden die Löcher L bzw. die Ringaussparungen LS geätzt. Anschließend wird ganzflächig ein Hilfsoxid oder ein Phosphorglas (PSG oder PBSG) als Isolierschichtzone aufgetragen. Anschließend wird wiederum ganzflächig eine Polysiliziumschicht, Nitrid-, Metall- oder Silikatglasschicht (PSG, BPSG) abgeschieden, die so als Schicht 14 strukturiert wird, daß vorzugsweise über den Löchern L des Masseteils gleichgeartete Löcher Lp entstehen. Die Löcher L, LS bzw. Lp in den Schichten 12, MT und 14 müssen als Durchgangslöcher ausgebildet sein. Anschließend werden durch selektive Ätzung durch die Löcher in der Schicht 14 die strukturierte Isolierschichtzone 13 gebildet und durch die Löcher L und LS in den Bereichen 12 (teilweise) und MT (vollständig) die erste Isolierschicht entfernt. Die Zone 11 unter Bereich 12 bleibt stehen. Dadurch wird das Masseteil MT freigelegt, so daß es nur noch an den Federelementen F 20 und F 21 aufgehängt ist. In den Stützenbereichen ST bleibt über dem Substrat 10 eine Stütze bestehen, die gemäß Figur 8 aus der Schichtenfolge 11, 12 und 13 besteht. Diese Stütze ist eine durchgehende mechanische Verbindung zwischen dem Substrat 10 und der Polysiliziumschicht 14. Eine ähnliche Stützenkonstruktion ist beim ersten Ausführungsbeispiel möglich.

Nachfolgend wird über der Polysiliziumschicht 14 eine Abdeckschicht als Abdeckung D, z.B. eine Isolierschicht aufgetragen. Diese Abdeckschichtschicht kann aus Nitrid, d.h. Plasmanitrid oder Passivierungsnitrid, aus Phophorglas (PSG oder BPSG) bestehen oder eine TEOS-Schicht sein. Weiterhin kann eine Metall- oder Polysiliziumschicht vorgesehen sein. Die Abscheidung der Schicht erfolgt beispielsweise durch konforme Abbildung. Entscheidend ist, daß die Locher in der Schicht 14 durch diese Schicht verschlossen werden. Eventuelle Abscheidungen AS, die bei diesem Prozeßschritt auf dem Substrat 10 oder auf der beweglichen Elektrode MT entstehen, sind nicht nachteilig, sondern erwünscht, da dadurch die Eletroden des Sensors allerhöchstens punktuell aufliegen können und so ein Sticking-Problem ohne weitere chemische Prozeßschritte weitgehend vermieden wird.

Die auf diese Weise erzeugte Abdeckung D kann weiter verstärkt werden, indem zusätzliche Schichten, beispielsweise eine Mehrlagenmetallisierung aufgetragen bzw. abgeschieden wird. Üblicherweise wird als obere abdeckende Schicht eine Passivierungsschicht aufgetragen. Die Dicke der über Polysiliziumschicht 14 abgeschiedenen Deckelschicht kann etwa 1 bis 4 µm betragen. Die Dimensionierung erfolgt so, daß die Abdeckung D dem maximalen Verpreßdrücken standhält.

Die in Figur 8 gezeigten Abmessungen ergeben sich aus den lateralen Ätzweiten bei der selektiven Freiätzung des Masseteils MT unter der Berücksichtigung, daß Stützen ST stehenbleiben müssen. So ist bei einer Lochöffnung d des Lochs L von etwa 0,7 bis 1,5 µm und einer lateralen Ätzweite a entsprechend ungefähr b/2 von 3 bis 4 µm ein Lochmittenabstand von 5 bis 8 µm vorgesehen. Die Breite c des Stützenfußes sollte etwa 3 bis 4 µm betragen, der Sützenabstand etwa 10 bis 25 µm. Bei der Herstellung des Deckels D kann in üblicher Weise durch eine Temperaturbehandlung eine Verdichtung des Materials erfolgen.

Die Erfindung hat den Vorteil, daß in allen drei Dimensionen eine mechanische Überlastsicherung vorhanden ist. Grundsätzlich eignet sich die Erfindung zum Eingraben in einem Substrat mittels CVD-Oxid, Plasma-Nitrid, selektiver Epitaxie oder anderen Verfahren für andere Materialien, z. B. Metalle.

Damit ist eine billige Plastikmontage und eine Standardbehandlung vereinzelter Chpis bei der Gehäuseherstellung möglich. Insbesondere bei einem hohen Integrationsgrad, d.h. bei einem Sensor mit Auswertelektronik und Ausgangs-Leistungstransistoren ergibt sich so eine erhebliche Verbilligung des integrierten Sensors. Dies ist für Massenanwendungen, beispielsweise zur Verzögerungsmessung bei Airbag-Systemen oder bei anderen Sensorsystemen von ausschlaggebender Bedeutung.

Weiterhin eignet sich die Erfindung sowohl für bekannte Sensoranordnungen mit Polysilizium als Sensorelementen als auch für Monosilizium-Sensorelemente. Die Erfindung ist unter Verwendung bekannter und verfügbarer Ätz- und Auffüllverfahren vollständig VLSI-kompatibel. Sie kann grundsätzlich mit allen bekannten Halbleitertechnologien kombiniert werden. Insbesondere bei der im ersten Ausführungsbeispiel dargestellten Technologie ist eine integrierte Sensorherstellung ohne wesentliche Erhöhung der erforderlichen Maskenzahl möglich. Daraus ergeben sich weitere erhebliche Kostenvorteile. Dotierungs- und Maßangaben der Beschreibung sind nur Beispielsangaben. Bei anderen Sensoren können andere Maße oder Dotierungen zweckmäßig sein, z. B. kann eine Dotierung der Grabenwände im Sensorbereich gegebenenfalls entfallen, wobei die Transistorstruktur in an sich bekannter Technologie erzeugt wird.

## Patentansprüche

1. Verfahren zur Herstellung einer mikromechanischen Vorrichtung mit einem beweglichen Element mit folgenden Schritten:
- ein Körper, bei dem auf einem Träger (1, 10) eine erste ganzflächige Isolierschicht (2, 11) und darüber eine ganzflächige Siliziumschicht (3,12) angeordnet ist, wird gebildet,
- die Siliziumschicht (3,12) wird strukturiert, wobei Öffnungen (L, LS) bis auf die erste Isolierschicht (2, 11) gebildet werden, die das herzustellende bewegliche Element (BE1, BE2) nach dessen Herstellung umgeben,
- eine Isolierschichtzone (IS, 13), die sich über den Öffnungen (L, LS) und dem herzustellenden beweglichen Element (BE1, BE2) erstreckt, und eine ganzflächige weitere Schicht (P, 14) werden aufgetragen,
- die weitere Schicht (P, 14) wird strukturiert, wobei oberhalb des herzustellenden beweglichen Elementes (BE1, BE2) Fenster (F) bis auf die Isolierschichtzone (IS, 13) gebildet werden,
- mit Hilfe der strukturierten weiteren Schicht (P, 14) als Maske werden die Isolierschichtzone (IS, 13) und die darunter liegenden Bereiche der ersten Isolierschicht (2, 11) selektiv derart geätzt, daß Teile der Siliziumschicht (3, 12) freigelegt werden und so das bewegliche Element (BE1, BE2) fertiggestellt wird,
- über der weiteren Schicht (P, 14) wird eine Deckschicht (D) als flächige Abdeckung unter Bildung eines das bewegliche Element enthaltenden abgeschlossenen Hohlraums (H) aufgetragen.

2. Verfahren nach Anspruch 1,
**dadurch gekennzeichnet,**
daß als Siliziumschicht eine einkristalline oder eine polykristalline Schicht vorgesehen sind.

3. Verfahren nach Anspruch 1 oder 2,
**dadurch gekennzeichnet**,
daß nach dem Strukturieren der Siliziumschicht die Öffnungen mit einem Isolierstoff aufgefüllt werden, der während des selektiven Ätzschrittes zumindest in Teilzonen wieder entfernt wird.

4. Verfahren nach einem der Ansprüche 1 bis 3,
**dadurch gekennzeichnet,**
daß die Isolierschichtzone zumindest in dem Bereich gebildet wird, der für bewegliche Elemente der Vorrichtung vorgesehen ist.

5. Verfahren nach einem der Ansprüche 1 bis 4,
**dadurch gekennzeichnet,**
daß die Isolierschichtzone durch lokale Oxidation gebildet wird.

6. Verfahren nach einem der Ansprüche 1 bis 5,
**dadurch gekennzeichnet,**
daß die weitere Schicht als Passivierungsschicht gebildet wird.

7. Verfahren nach einem der Ansprüche 1 bis 6,
**dadurch gekennzeichnet,**
daß die weitere Schicht als Nitridschicht, Siliziumnitridschicht, Phosphorglasschicht, Metallschicht oder als Oxidschicht gebildet wird.

8. Verfahren nach einem der Ansprüche 1 bis 7,
**dadurch gekennzeichnet,**
daß als Isolierschichtzone eine Oxidschicht, eine Nitridschicht oder eine Phosphorglasschicht aufgetragen wird.

9. Verfahren nach einem der Ansprüche 1 bis 8,
**dadurch gekennzeichnet,**
daß in einem beweglichen Teil der Vorrichtung Stützen (ST) für die Abdeckung (D) gebildet werden, die von einem umgebenden beweglichen Teil (MT) getrennt sind.

10. Mikromechanische Vorrichtung, die in einem mikromechanischen Bereich folgende Merkmale enthält:
- einen Träger (1, 10),
- eine über dem Träger angeordnete strukturierte Isolierschicht (2, 11),
- eine Siliziumschicht (3, 12), die einen ersten Teilbereich (FE1, FE3) aufweist, der von der darunterliegenden Isolierschicht (2, 11) getragen wird, und einen zweiten, beweglichen Teilbereich (BE1, BE2), der keine darunter liegende Isolierschicht aufweist,
- eine weitere Schicht (P, 14) über der Siliziumschicht (3, 12), die zumindest im Bereich des zweiten Teilbereiches (BE1, BE2) nicht mit der Siliziumschicht (3, 12) in Kontakt steht und dort Fenster (F, L) aufweist,
- eine Deckschicht (D) als flächige Abdeckung über der weiteren Schicht (P, 14), durch welche ein den beweglichen Teilbereich enthaltenden abgeschlossener Hohlraum (H) erzeugt ist.

11. Vorrichtung nach Anspruch 10,
**dadurch gekennzeichnet,**
daß der Bereich eine mikromechanische Anordnung in einer einkristallinen Halbleiterschicht enthält.

12. Vorrichtung nach Anspruch 10 oder 11,
**dadurch gekennzeichnet**, daß
die Deckschicht (D) eine Polysiliziumschicht und/oder eine Nitridschicht und/oder eine Phosphorglasschicht oder eine Kombination dieser Schichten enthält.

13. Vorrichtung nach einem der Absprüche 10 bis 12,
**dadurch gekennzeichnet,** daß
unter der Deckschicht (D) eine strukturierte Passivierungsschicht oder eine strukturierte Polysiliziumschicht oder eine strukturierte Metallschicht vorgesehen ist.

14. Vorrichtung nach einem der Ansprüche 10 bis 13,
**dadurch gekennzeichnet**, daß
die Deckschicht (D) durch Stützen (ST), die durch Öffnungen (LS) in einem beweglichen Teil (MT) des mikromechanischen Bereichs gehen, und durch einen nicht beweglichen Teil des mikromechanischen Bereichs getragen wird.

15. Vorrichtung nach Anspruch 14,
**dadurch gekennzeichnet**, daß
die Stützen eine Schichtenfolge aus einer ersten Isolierschicht (11), einer Siliziumschicht (12) und einer Isolierschichtzone (13) enthalten, wobei die Siliziumschicht mit dem beweglichen Teil (MT) des mikromechanischen Bereichs hergestellt ist.

16. Vorrichtung nach einem der Ansprüche 10 bis 15,
**dadurch gekennzeichnet**, daß
eine Transistoranordnung mit der mikromechanischen Vorrichtung integriert ist.

## Claims

1. Method for the production of a micromechanical device having a movable element, having the following steps:
- a body is formed in which a first whole-area insulating layer (2, 11) is arranged on a carrier (1, 10) and a whole-area silicon layer (3, 12) is arranged over said insulating layer,
- the silicon layer (3, 12) is structured, openings (L, LS) being formed down to the first insulating layer (2, 11), which openings surround the movable element (BE1, BE2) to be produced after its production,
- an insulating layer region (IS, 13), which extends over the openings (L, LS) and the movable element (BE1, BE2) to be produced, and a whole-area further layer (P, 14) are applied,
- the further layer (P, 14) is structured, windows (F) down to the insulating layer region (IS, 13) being formed above the movable element (BE1, BE2) to be produced,
- the insulating layer region (IS, 13) and the regions of the first insulating layer (2, 11) which are situated underneath it are selectively etched with the aid of the structured further layer (P, 14) as a mask, in such a way that parts of the silicon layer (3, 12) are exposed and the movable element (BE1, BE2) is completed in this way,
- a covering layer (D) is applied over the further layer (P, 14) as a planar covering, forming a closed cavity (H) containing the movable element in the process.

2. Method according to Claim 1, characterized in that a monocrystalline or a polycrystalline layer is provided as the silicon layer.

3. Method according to Claim 1 or 2, characterized in that the openings are filled with an insulating material following the structuring of the silicon layer, which insulating material is removed again at least in subregions during the selective etching step.

4. Method according to one of Claims 1 to 3, characterized in that the insulating layer region is formed at least in that region which is provided for movable elements of the device.

5. Method according to one of Claims 1 to 4, characterized in that the insulating layer region is formed by local oxidation.

6. Method according to one of Claims 1 to 5, characterized in that the further layer is formed as a passivation layer.

7. Method according to one of Claims 1 to 6, characterized in that the further layer is formed as a nitride layer, silicon nitride layer, phosphorus glass layer, metal layer or as an oxide layer.

8. Method according to one of Claims 1 to 7, characterized in that an oxide layer, a nitride layer or a phosphorus glass layer is applied as the insulating layer region.

9. Method according to one of claims 1 to 8, characterized in that supports (ST) are formed for the covering (D) in a movable part of the device, which supports are separated from a surrounding movable part (MT).

10. Micromechanical device, which contains the following features in a micromechanical region:
- a carrier (1, 10),
- a structured insulating layer (2, 11) arranged over the carrier,
- a silicon layer (3, 12) having a first subregion (FE1, FE3), which is borne by the insulating layer (2, 11) situated underneath it, and a second, movable subregion (BE1, BE2), which has no insulating layer situated underneath it,
- a further layer (P, 14) over the silicon layer (3, 12), which, at least in the region of the second subregion (BE1, BE2), is not in contact with the silicon layer (3, 12) and has windows (F, L) there,
- a covering layer (D) as a planar covering over the further layer (P, 14), by which a closed cavity (H) containing the movable subregion is produced.

11. Device according to Claim 10, characterized in that the region contains a micromechanical arrangement in a monocrystalline semiconductor layer.

12. Device according to Claim 10 or 11, characterized in that the covering layer (D) contains a polysilicon layer and/or a nitride layer and/or a phosphorus glass layer or a combination of these layers.

13. Device according to one of Claims 10 to 12, characterized in that a structured passivation layer or a structured polysilicon layer or a structured metal layer is provided under the covering layer (D).

14. Device according to one of Claims 10 to 13, characterized in that the covering layer (D) is borne by supports (ST), which pass through openings (LS) in a movable part (MT) of the micromechanical region, and by an immovable part of the micromechanical region.

15. Device according to Claim 14, characterized in that the supports contain a layer sequence formed by a first insulating layer (11), a silicon layer (12) and an insulating layer region (13), the silicon layer being produced with the movable part (MT) of the micromechanical region.

16. Device according to one of Claims 10 to 15, characterized in that a transistor arrangement is integrated with the micromechanical device.

## Revendications

1. Procédé de fabrication d'un dispositif micromécanique pourvu d'un élément mobile, comprenant les étapes suivantes :
- on forme un élément en disposant sur un substrat (1, 10) une première couche isolante (2, 11) sur toute la surface, et au-dessus une couche de silicium (3, 12) sur toute la surface,
- on structure la couche de silicium (3, 12), des ouvertures (L, LS) étant formées jusqu'à la première couche isolante (2, 11), qui entourent l'élément mobile (BE1, BE2) à la suite de sa réalisation,
- on applique une zone de couche isolante (IS, 13) qui s'étend sur les ouvertures (L, LS) et l'élément mobile (BE1, BE2) à réaliser, et on applique une couche supplémentaire (P, 14) sur toute la surface,
- on structure la couche supplémentaire (P, 14). des fenêtres (F) étant formées au-dessus de l'élément mobile (BE1, BE2) à réaliser jusqu'à la zone de couche isolante (IS, 13),
- en se servant comme masque de la couche supplémentaire structurée (P, 14), on soumet à une attaque chimique sélective la zone de couche isolante (IS, 13) et les régions sous-jacentes de la première couche isolante (2, 11) de telle sorte que des parties de la couche de silicium (3, 12) sont dégagées et que l'élément mobile (BE1, BE2) est ainsi fini,
- on applique au-dessus de la couche supplémentaire (P, 14) une couche de recouvrement (D) comme recouvrement en nappe. en formant une cavité fermée (H) contenant l'élément mobile.

2. Procédé selon la revendication 1, caractérisé en ce qu'une couche monocristalline ou polycristalline est prévue comme couche de silicium.

3. Procédé selon la revendication 1 ou 2, caractérisé en ce que, à la suite de la structuration de la couche de silicium, les ouvertures sont remplies d'une substance isolante qui, lors de l'étape d'attaque chimique sélective, est éliminée au moins dans des zones partielles.

4. Procédé selon l'une des revendications 1 à 3, caractérisé en ce que la zone de couche isolante est formée au moins dans la région prévue pour des éléments mobiles du dispositif.

5. Procédé selon l'une des revendications 1 à 4, caractérisé en ce que la zone de couche isolante est formée par oxydation locale.

6. Procédé selon l'une des revendications 1 à 5, caractérisé en ce que la couche supplémentaire est réalisée sous forme de couche de passivation.

7. Procédé selon l'une des revendications 1 à 6, caractérisé en ce que la couche supplémentaire est réalisée sous forme de couche de nitrure, couche de nitrure de silicium, couche d'acide métaphosphorique, couche métallique ou couche d'oxyde.

8. Procédé selon l'une des revendications 1 à 7, caractérisé en ce qu'on applique comme zone de couche isolante une couche d'oxyde, couche de nitrure ou couche d'acide métaphosphorique.

9. Procédé selon l'une des revendications 1 à 8, caractérisé en ce que des supports (ST) pour le recouvrement (D) sont formés dans une partie mobile du dispositif, en étant séparés d'une partie mobile entourante (MT).

10. Dispositif micromécanique, qui présente, dans une région micromécanique, les caractéristiques suivantes :
- un substrat (1, 10)
- une couche isolante structurée (2, 11), disposée sur le substrat,
- une couche de silicium (3, 12), qui présente une première région partielle (FE1, FE3) qui est portée par la couche isolante sous-jacente (2, 11), et une deuxième région partielle (BE1, BE2), mobile, qui ne présente pas de couche isolante sous-jacente,
- une couche supplémentaire (P, 14), qui est disposée au-dessus de la couche de silicium (3, 12) et qui, au moins dans la région de la deuxième région partielle (BE1, BE2), n'est pas en contact avec la couche de silicium (3, 12) et y présente des fenêtres (F, L),
- une couche de recouvrement (D) comme recouvrement en nappe au-dessus de la couche supplémentaire (P, 14), qui produit une cavité fermée (H) contenant la région partielle mobile.

11. Dispositif selon la revendication 10, caractérisé en ce que la région micromécanique contient un montage micromécanique dans une couche semi-conductrice monocristalline.

12. Dispositif selon la revendication 10 ou 11, caractérisé en ce que la couche de recouvrement (D) comprend une couche de polysilicium et/ou une couche de nitrure et/ou une couche d'acide métaphosphorique, ou une combinaison de ces couches.

13. Dispositif selon l'une des revendications 10 à 12, caractérisé en ce qu'une couche de passivation structurée ou une couche de polysilicium structurée ou une couche métallique structurée est prévue sous la couche de recouvrement (D).

14. Dispositif selon l'une des revendications 10 à 13, caractérisé en ce que la couche de recouvrement (D) est portée par des supports (ST), qui s'étendent par ces ouvertures (LS) ménagées dans une partie mobile (MT) de la région micromécanique, et par une partie non mobile de la région micromécanique.

15. Dispositif selon la revendication 14, caractérisé en ce que les supports contiennent une succession de couches constituée d'une première couche isolante (11), d'une couche de silicium (12) et d'une zone de couche isolante (13), la couche de silicium étant réalisée avec la partie mobile (MT) de la région micromécanique.

16. Dispositif selon l'une des revendications 10 à 15, caractérisé en ce qu'un montage de transistor est intégré au dispositif micromécanique.
